# EUROPÄISCHE PATENTANMELDUNG

(11) **EP 4 686 369 A1**
(43) Veröffentlichungstag der Anmeldung: **28.01.2026**
(21) Anmeldenummer: 25191911.4
(22) Anmeldetag: 25.07.2025
(51) Int. Cl.: H10N 10/13, H10N 10/17, H10N 10/82

(54) **THERMOELEKTRISCHES COMPOUND-MODUL**

(30) Priorität: 25.07.2024 DE 102024121219
(71) Anmelder: Deutsches Zentrum für Luft- und Raumfahrt e.V., 53227 Bonn (DE); Technische Hochschule Nürnberg Georg Simon Ohm in Vertretung des Freistaates Bayern, 90489 Nürnberg (DE)
(72) Erfinder: MÜLLER, Eckhard, 53604 Bad Honnef (DE); STIEWE, Christian, 51147 Köln (DE); METZ, Thomas, 90449 Nürnberg (DE); STUMPF, Arne, 90427 Nürnberg (DE)
(74) Vertreter: dompatent

(57) **Zusammenfassung**

Die Erfindung betrifft ein thermoelektrisches Compound-Modul (10) mit einem heißseitigen Wärmeübertrager (2) zur Befestigung bzw. thermischen Kopplung des thermoelektrischen Compound-Moduls (10) an eine Wärmequelle, einem kaltseitigen Wärmeübertrager (3) zur Befestigung bzw. thermischen Kopplung des thermoelektrischen Compound-Moduls an einem Wärmeabnehmer, einem oder mehreren thermoelektrischen Modulen (1), die zwischen dem heißseitigen Wärmeübertrager (2) und dem kaltseitigen Wärmeübertrager (3) angeordnet sind, dadurch gekennzeichnet, dass das thermoelektrische Compound-Modul (10) eine Verkapselung (5) aufweist, die sich zumindest von dem heißseitigen Wärmeübertrager (2) zum kaltseitigen Wärmeübertrager (3) erstreckt und die die thermoelektrischen Module (1) vollständig umschließt und gegen äußere Einflüsse abdichtet.

## Beschreibung

Die Erfindung betrifft ein thermoelektrisches Compound-Modul.

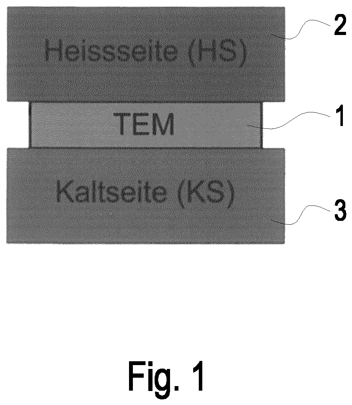

Thermoelektrische Generatoren (TEG) werden zur Wandlung von Wärmeströmen in elektrische Leistung, z. B. von ungenutzter Abwärme in technischen Anlagen oder Fahrzeugen, eingesetzt. Hierfür werden thermoelektrische Module (TEM) einem Temperaturgradienten zwischen zwei beiderseits angeordneten Wärmetauschern - einer z.B. durch Strahlung, heiße strömende Flüssigkeiten, Gase oder andere Medien erwärmten heißen Seite (HS) und einer typischerweise durch ein strömendes kaltes Medium gekühlten kalten Seite (KS) - ausgesetzt. Dies ist in Figur 1 dargestellt.

Die Thermoelektrik bietet prinzipiell eine interessante Möglichkeit zur direkten Erzeugung von elektrischem Strom aus Abwärme und Verbrennungsprozessen. Neben der Nutzung von Niedertemperaturabwärme (<300 °C) sind insbesondere Hochtemperaturprozesse (>300 °C) aus Gründen ihres höheren thermodynamischen Wirkungsgrades von besonderem Interesse. Hochtemperaturabwärme tritt u.a. bei thermischen Prozessen, z. B. in der Stahl-, Glas-, Keramik- und Baustoffindustrie (beispielsweise in der Kupfer-, Aluminium-, Zementherstellung, etc.) auf. Bei Verbrennungsprozessen bieten sich insbesondere Kessel zur Warmwasserbereitstellung an, aber auch die Nutzung der Wärme in Abgasströmen von Motoren, Gasturbinen oder Anlagen zur thermischen Nachverbrennung (TNV) sind mögliche Einsatzfelder. Neben dem Anwendungsfall der Stromerzeugung kann die Thermoelektrik auch zu Kühlzwecken durch sog. Peltier-Kühler sowie zu Heiz- oder Thermalisierungszwecken, durch sog. Peltier-Wärmepumpen Anwendung finden.

Thermogeneratoren (TEG) können Wärme direkt in elektrische Leistung umwandeln und haben deshalb ein breites Anwendungspotential (Abgas-Abwärmenutzung im PKW, Abwärmenutzung in der Stahl- und Aluminiumindustrie, in der Baustoff- und Keramik-Herstellung, in Schiffen und Flugzeugen, für autarke netzferne Stromversorgung, z. B. für das Umweltmonitoring oder Telekommunikationseinrichtungen, zur elektrischen Versorgung autarker Sensoren in vielfältigen technischen Systemen, für physiologisches Monitoring in der Medizin und im Sport- und Freizeit-Sektor u.v.a.). TEM sind aus einer Vielzahl von definiert (oft prismatisch) geformten halbleitenden Schenkeln aufgebaut, welche durch metallische Kontaktbrücken miteinander verbunden und dadurch elektrisch in Reihe geschaltet werden.

In bisherigen Anlagen zur Verstromung von Abwärme mittels TEG wurden die TEM durch speziell angefertigte Vorrichtungen meist kraftschlüssig an die Wärmequellen bzw. -senken angekoppelt (z.B. durch einfache Verschraubung der Komponenten). Dabei sind die erzielten Wärmeübergänge oftmals unzureichend, was zu einer deutlich verringerten Leistungsausbeute des TEG führt. Zudem sind solche Individual-Lösungen für die Kopplung der TEM mit den Wärmetauscherkomponenten sehr kostenintensiv und oft nur bedingt serientauglich.

Ein aus dem Stand der Technik bekanntes thermoelektrisches Modul ist in US 2012/010338 A1 dargestellt.

Thermoelektrische Module (TEM) sind oft filigrane, mechanisch, korrosiv und funktionell empfindliche Bauteile, deren Einbindung in raue Prozessumgebungen wie Feuerräume und Abgaskanäle eine komplexe und bisher unzureichend gelöste Problematik darstellt. Als technische Herausforderungen sind hier u.a. zu nennen:
a) mechanische Befestigung ohne den Eintrag zusätzlicher thermischer Kopplung, die thermische Nebenschlüsse zum TEM verursachen würde,
b) temperaturinduzierte mechanische Spannungen im TEM aufgrund unterschiedlicher Wärmedehnung auf heißer und kalter Seite,
c) (unzureichende) Anpassung des vom System bereitgestellten Wärmestroms durch das TEM auf dessen geometrische Auslegung,
d) Bypass-Wärmeverluste im System parallel zum TEM zwischen Heiß- und Kaltseite,
e) kaltseitige Wärmeabführung vom TEM,
f) thermische Kopplung mit geringen Temperatursprüngen am TEM,
g) elektrische Kontaktierung der thermoelektrischen Hochleistungsmaterialien,
h) elektrische Kabeldurchführungen,
i) thermische Degradation des TE-Funktionsmaterials u.a. durch Oxidation mit Luftsauerstoff und
j) Kontakt mit Kondensat oder Ablagerungen aus dem Heißgas (Beeinträchtigung des Wärmeübergangs und korrosiver Angriff)

Hinzu kommt, dass die spezifischen Kosten für die Thermoelektrik, z.B. bei Anwendung als Generator bisher für einen wirtschaftlichen Einsatz zu hoch sind. Neben den genannten technischen Hürden ist dabei der Hauptgrund, dass die Stückzahlen thermoelektrischer Module bisher zu gering sind und daher keine kostengünstige Serienfertigung der TEM möglich war. Bisher sind keine Lösungen bekannt, womit - z.B. für Heizgerätehersteller - die Integration der Thermoelektrik in einen Heizkessel mit üblichen Ingenieurmethoden realisierbar wäre.

Es ist Aufgabe der Erfindung, ein thermoelektrisches Modul bereitzustellen, das die genannten Nachteile minimiert.

Die Lösung der Aufgabe erfolgt erfindungsgemäß durch ein thermoelektrisches Compound-Modul gemäß Anspruch 1 sowie ein Array gemäß Anspruch 10.

Das thermoelektrische Compound-Modul gemäß der vorliegenden Erfindung weist einen heißseitigen Wärmeübertrager zur Befestigung und/oder Kontaktierung an eine Wärmequelle und einen kaltseitigen Wärmeübertrager zur Befestigung und/oder Kontaktierung (d.h. thermische Kopplung) an einen Wärmeabnehmer (d.h. eine Wärmeabführung) oder eine Wärmsenke auf. Weiterhin sind ein oder mehrere thermoelektrische Elemente bzw. Module vorgesehen, die zwischen dem heißseitigen und dem kaltseitigen Wärmeübertrager angeordnet sind. Insoweit entspricht das thermoelektrische Compound-Modul dem Stand der Technik.

Es weist ferner eine Verkapselung auf, die sich zumindest vom heißseitigen Wärmeübertrager zum kaltseitigen Wärmeübertrager erstreckt und welche die thermoelektrischen Module vollständig umschließt und gegen äußere Einflüsse abdichtet.

Das erfindungsgemäße thermoelektrische Compound-Modul bietet somit eine robuste konstruktive Standardlösung, um Wärmetauscherkomponenten effektiv an die thermoelektrischen Wandlermodule mit möglichst geringen Verlusten in Folge thermischer Übergangswiderstände anzukoppeln. Weiterhin stellt die insbesondere gasdichte Verkapselung des thermoelektrischen Compound-Moduls einen wirksamen Schutz für die empfindlichen thermoelektrischen Module gegen Oxidation und/oder das Abdampfen/Sublimieren chemischer Bestandteile aus dem thermoelektrischen Funktionsmaterial und ferner gegen mechanische Belastungen, z. B. durch Vibration, dar. Die vorliegende Erfindung trägt somit dazu bei, die Nutzung von thermoelektrischen Modulen standardisierbar serientauglich, unabhängig von der chemischen und Atmosphärenumgebung sowie dem Einbauzustand im System und damit insgesamt wirtschaftlicher zu machen.

Erfindungsgemäß können verschiedene Arten von thermoelektrischen Modulen zum Einsatz kommen, beispielsweise:
- thermoelektrische Niedertemperatur-Module auf Basis von Bi₂Te₃-Materialien,
- thermoelektrische Hochtemperatur-Module auf Basis von Halb-Heusler-Materialien,
- thermoelektrische Hochtemperatur-Module auf Basis von Skutterudit-Materialien,
- thermoelektrische Module auf Basis von beliebigen anderen thermoelektrische Materialen (Heusler-Legierungen (z. B. FezVAl-Verbindungen), Mg₂(Si,Sn,Ge)-Verbindungen, MgAgSb-Verbindungen, Mg₃(Sb,Bi)₂-Verbindungen, Zintl-Verbindungen (z.B. Yb₁₄MnSb₁₁ u.v.a.), einfachen, komplexen oder nanostrukturierten Telluriden, Antimoniden (z. B. Zink-Antimonid), quaternären Chalcogeniden, Seleniden (z. B. Cu₂Se- und Ag₂Se-basierte Verbindungen), Sulfiden, Tetraedriten, Argyroditen, Eisen-, Mangan- und weiteren Metallsilizid-Verbindungen und ihren Mischkristallen sowie thermoelektrischen Metalllegierungen)
- sowie TEM mit Kombinationen unterschiedlicher thermoelektrischer Materialen bzw. Modultypen.

Das erfindungsgemäße thermoelektrische Compound-Modul zeichnet sich dadurch aus, dass die breite Komplexität des thermoelektrischen Anwendungssystems (Integration der thermoelektrischen Module in Wärmetauscherkomponenten, Einbindung in das Zielsystem, Gestaltung von Wärmeübergängen, Unterbindung von Korrosion usw.) so weit wie möglich in kleine standardisierbare, komplett fabrikfertigbare Komponenten, nämlich thermoelektrische Compound-Module (TECM), integriert wird.

Damit kann einerseits die Komplexität eines Gesamtsystems bestehend aus Thermoelektrik, Wärmetauscher und Wärmequelle bzw. -senke deutlich reduziert werden und eine komplizierte, fehleranfällige Anpassung und Justierung bei der Systemmontage, z. B. unter Feldbedingungen an industriellen und technischen Anlagen, vermieden werden. Andererseits lassen sich die o.g. technisch kritischen Aspekte (a bis j) durch eine industrielle, hochautomatisierte Serienfertigung standardisierter einzelner TECM lösen, da so eine hohe Reproduzierbarkeit bei der Herstellung und ein Höchstmaß an Qualitätssicherung realisiert werden kann.

Es ist bevorzugt, dass der kaltseitige Wärmeübertrager eine thermisch geschützte Durchführung für elektrische Anschlüsse aufweist. Hierdurch kann eine Überhitzung der elektrischen Anschlüsse vermieden werden. Eine Überhitzung würde z.B. bedeuten, dass sich Lötstellen lösen oder die elektrische Kabelisolierung aus Kunststoffen/Polymeren/Silikon zerstört wird.

Somit kann ein elektrischer Kurzschluss und eine damit verbundene Verringerung des Wirkungsgrades bzw. ein Ausfall des thermoelektrischen Moduls vermieden werden.

Das thermoelektrische Compound-Modul weist ferner bevorzugt mindestens eine Spannvorrichtung zur Verbindung des heißseitigen Wärmeübertragers mit dem kaltseitigen Wärmeübertrager auf. Durch die Spannvorrichtung erfolgt eine definierte mechanische Anpressung von heißseitigem Wärmeübertrager und kaltseitigem Wärmeübertrager an die thermoelektrischen Module, wobei die mindestens eine Spannvorrichtung in radialer Richtung außerhalb der Verkapselung angeordnet ist.

Die Fügung des heißseitigen Wärmeübertragers und des kaltseitigen Wärmeübertragers mit dem thermoelektrischen Modul im TECM kann stoffschlüssig, formschlüssig, kraftschlüssig oder durch beliebige Kombinationen hiervon erfolgen.

Im Falle einer kraftschlüssigen Fügung, beispielsweise durch mindestens eine Spannvorrichtung, weist diese bevorzugt einen hohen thermischen Widerstand auf, um thermische Nebenschlüsse durch die Komponenten der Spannvorrichtung selbst zu verringern. Es ist bevorzugt, dass der thermische Widerstand (gemessen in Kelvin pro Watt) der Spannvorrichtung ca. um mindestens den Faktor 10 höher ist als der thermische Widerstand der thermoelektrischen Module.

Weiterhin ist es bevorzugt, dass die Verkapselung des thermoelektrischen Compound-Moduls gasdicht ist und insbesondere eine Folie aufweist, die gasdicht mit dem heißseitigen Wärmeübertrager und dem kaltseitigen Wärmeübertrager verbunden ist. Ferner ist vorzugsweise eine gasdichte Verfüllung der Kabeldurchführungen vorgesehen. Durch die gasdichte Folie kann eine hermetische Trennung von der Prozessumgebung erreicht werden. Die Verwendungeiner thermisch stabilen Folie ist hierbei bevorzugt. Diese weist bevorzugt einen hohen thermischen Widerstand auf. Auch hier ist es bevorzugt, dass der thermische Widerstand (gemessen in Kelvin pro Watt) der Folie ca. um mindestens den Faktor 10 höher ist als der thermische Widerstand der thermoelektrischen Module. Geeignete Materialien richten sich nach dem Temperaturniveau. Bei niedrigen Temperaturen unter 250 °C können Kunststoffe, Aluminium, Stahl, Keramik der Folie bzw. Kapselung zum Einsatz kommen und die Verbindung mit den heiß- und kaltseitigen Wärmeübertragerblöcken mittels Klebstoffen wie beispielsweise Silikon erfolgen. Bei höheren Temperaturen verringert sich die Materialauswahl auf legierte Stähle, Edelstahl, Keramik und die Verbindung mit dem heißseitigen Wärmetauscherblock kann durch Schweißen und/oder spezielle hochtemperaturbeständige Fügeverfahren (z.B. Hartlöten, Keramikkleber, etc.) erfolgen.

Der Umfang der Folie bzw. Kapselung kann eine beliebige Form aufweisen, zum Beispiel rechteckig, polygonförmig, kreiszylindrisch etc. Eine kreiszylindrische Ausgestaltung ist bevorzugt, um gegen Über- bzw. Unterdruck im Innenraum eine bessere mechanische Stabilität aufzuweisen.

In einer weiteren bevorzugten Ausführungsform kann die Folie in Richtung vom kaltseitigen zum heißseitigen Wärmeübertrager eine Wellenform oder Ziehharmonikaform aufweisen. Sie ist somit noch effektiver gegenüber- bzw. Unterdruck im Hohlraum geschützt sowie flexibel gegenüber thermischen Längenänderungen.

Weiterhin ist es bevorzugt, dass der Hohlraum zwischen dem heißseitigen Wärmeübertrager und dem kaltseitigen Wärmeübertrager mit einem thermischen und elektrischen Isoliermaterial verfüllt ist. Hierdurch wird der Wärmeverlust zwischen dem heißseitigen und kaltseitigem Wärmeübertrager sowohl aufgrund von Wärmestrahlung als auch durch freie Konvektion minimiert.

Alternativ kann der Hohlraum mit einem isolierenden Gas verfüllt oder evakuiert sein. Beispielsweise kann als isolierendes Gas Argon, Stickstoff oder Xenon verwendet werden. Das Gas weist bevorzugt eine geringe Wärmeleitfähigkeit und Wärmekapazität auf, ist chemisch hinsichtlich Korrosion inert und geht außerdem möglichst nicht durch Diffusion durch die Kapselung hindurch über einen längeren Zeitraum verloren.

Es ist weiterhin bevorzugt, dass das thermoelektrische Compound-Modul flächenoptimiert ausgeführt wird, so dass seine gesamte Grundfläche nur geringfügig größer ist als die des thermoelektrischen Moduls. Hierdurch kann der Bypass-Wärmeverlust durch Wärmeleitung oder Strahlungsaustausch zwischen freien Flächen des warmseitigen und kaltseitigen Wärmeübertrages minimiert werden. Es ist hierbei bevorzugt eine Spannvorrichtung in der Mitte des thermoelektrischen Compound-Moduls vorgesehen, um die, insbesondere umgebend, eine gasdichte Abdichtung vorgesehen ist. Die Spannvorrichtung übt eine Zugkraft zwischen dem heißseitigen mit dem kaltseitigen Wärmeübertrager aus, um diese an das thermoelektrische Modul anzupressen.

Weiterhin ist bevorzugt eine Kabeldurchführung aus dem Inneren des thermoelektrischen Compound-Moduls nach außen vorgesehen, die insbesondere eine gasdichte Abdichtung aufweist.

Das erfindungsgemäße Compound-Modul kann ein einziges oder mehrere übereinander gestapelte thermoelektrische Module enthalten. Gestapelte (oder kaskadierte) Module haben den Vorteil, dass bei sehr hohen anliegenden Temperaturdifferenzen ein höherer Wirkungsgrad der thermoelektrischen Energieumwandlung erreicht werden kann als mit einem einzelnen Modul, da die Eigenschaften der thermoelektrischen Materialien in einer charakteristischen Glockenkurve von der Temperatur abhängen, so dass ein gegebenes Material nur in einem Bereich von max. 200-300 K Breite gute Wirkungsgrade erreicht. Zu kaskadierten Modulen verbindet man deshalb mehrere einzelne thermoelektrische Module, die aus verschiedenen TE Materialien mit jeweils unterschiedlichem Temperaturbereich ihrer maximalen Performance hergestellt wurden, so dass die gesamte Temperaturdifferenz über dem Aufbau sich auf die kaskadierten Module so aufteilt, dass jedes Modul im Temperaturbereich seiner maximalen Leistung betrieben wird.

Die Erfindung betrifft ferner ein Array mit mehreren thermoelektrischen Compound-Modulen wie sie vorliegend beschrieben sind. Diese sind auf einer Kühlplatte montiert, durch die insbesondere Kühlmittelkanäle und Kabeldurchführungen verlaufen. Die Aufbringung der thermoelektrischen Compound-Module auf der Kühlplatte kann beispielsweise mittels Schrauben, Bolzen, Federn, Verklemmen in keilförmigen Halterungen und/oder Stiften erfolgen.

Ebenso können die Compound-Module alternativ an ihrer Heißseite fest in passenden Öffnungen einer Ofen- oder Kesselwandung montiert sein (mit gasdichter, aber ggf. gleitfähiger - zum Ausgleich thermischer Ausdehnung - Abdichtung) und auf ihrer Kaltseite, mit einer gegliederten Struktur, z. B. mit Noppen oder Rippen oder einer dreidimensionalen porösen Netzwerkstruktur besetzt, mechanisch miteinander flexibel verbunden, in einen z.B. aus Polymermaterial geformten Kanal abgedichtet eintauchen, der ein Kühlmedium führt.

Es ist in einer weiteren Ausführungsform bevorzugt, dass die Compound-Module nicht mit einem separaten, evtl. größeren, also an mehreren Compound-Modulen anschließenden heißseitigen Wärmeübertrager verbunden sind, sondern jedes Compound-Modul separiert von weiteren (üblicherweise vorhandenen, benachbart angeordneten) Compound-Modulen mechanisch am Kaltseiten-Wärmeübertrager fixiert ist. Auf der Heißseite kann eine metallische Abschlussplatte des Compound Moduls vorgesehen sein, die in anderen Ausführungsformen eine plane Endfläche für den thermischen Kontakt zum Heißseiten-Wärmeübertrager aufweist, hier aber als ein separater kleiner (so groß wie das Compound-Modul selbst) Wärmeübertrager mit Rippen, Noppen oder anderen Absorberstrukturen besetzt ausgebildet, die in das heiße Medium eintauchen und über die vergrößerte Oberfläche die Wärme daraus extrahieren. Entsprechend kann an der Basis dieser Bauteile, welche gleichzeitig Abschlussplatte und Wärmeübertrager ist, die Verkapselung wie bei allen anderen Ausführungsformen angebracht werden.

Relevant bei dieser Ausführungsform ist aufgrund der Vereinzelung der Heißseiten-Wärmeübertrager die Gestaltung der seitlichen Geometrie an den Stellen, wo sich benachbarte Module gegenüberstehen oder die erste / letzte Modulreihe einer angrenzenden Struktur gegenübersteht. Bevorzugt sollen die benachbarten Module / Strukturen hier nicht fest verbunden sein (aus Fertigungsgründen und zur Vermeidung von mechanischen Spannungen, die sich aus der thermischen Ausdehnung ergeben würden). Es muss jedoch verhindert werden, dass das heiße Medium zwischen den benachbarten Compound-Modulen bzw. Modulen und Randstruktur mit einem nicht vernachlässigbaren Massenstrom ein- oder ausströmt und damit einen thermischen Nebenschluss zum Kaltseiten-Wärmeübertrager bildet. Dies würde den Wirkungsgrad der Anordnung unerwünscht verringern und auch das Risiko anderer unerwünschter Effekte wie Kondensation oder korrosiven Angriff mit sich bringen. Bei mäßigen Heißseitentemperaturen können zur Vermeidung dieses Effekts hier flexibel dehnbare Polymerdichtungen verwendet werden, die als Rahmenraster mit Aussparungen für die Compound Module geformt sind, in die die separaten Heißseiten-Wärmeübertrager der Compound Module mit ihrem Umfang an der Basis eingesetzt werden.

Bei hohen Temperaturen des heißen Mediums, wo geeignete Polymere nicht zur Verfügung stehen, könnten dies andere flexible Lösungen wie z. B. flexible keramisch basierte Dichtschnüre, die aus der elektrischen Hochtemperatur-Isoliertechnik und Kamintechnik bekannt sind, oder aber randseitige unflexible Mehrfachlamellen sein, die an der Basis der Heiß-Wärmeübertrager eines jeden Compound Moduls und auch am Rand einer Umfassungsstruktur angebracht sind, die das Compound Modul-Array umgibt, und die an den Grenzlinien zwischen den Modulen von beiden Seiten ohne oder nur mit leichter Berührung, die keine relevante Kraft überträgt, ineinandergreifen und einen mäanderförmigen breiten Spalt bilden, durch den nur eine unwesentlich geringe Menge des heißen Mediums hindurchtritt (und dabei schon so viel Wärme mit den Lamellen austauscht, dass kein relevanter thermischer Nebenschluss mehr stattfindet). Bevorzugt sind somit zwischen den thermoelektrischen Compound-Modulen Spalte ausgebildet, die mit einem flexiblen, temperaturbeständigen Isoliermaterial verfüllt sind. Hierfür können beispielsweise Mineralwolle, Keramikfasermatten oder Formteile aus pyrogener Kieselsäure verwendet werden.

Im Folgenden werden bevorzugte Ausführungsformen der Erfindung anhand von Figuren erläutert.

Es zeigen:
- Fig. 1: ein thermoelektrisches Modul gemäß dem Stand der Technik
- Fig. 2: eine erste Ausführungsform eines erfindungsgemäßen thermoelektrischen Compound-Moduls
- Fig. 3: eine zweite Ausführungsform eines erfindungsgemäßen thermoelektrischen Compound-Moduls
- Fig. 4: ein Array mit mehreren thermoelektrischen Compound-Modulen gemäß einer weiteren Ausführungsform der Erfindung.

Figur 1 wurde bereits im Zusammenhang mit dem Stand der Technik erläutert.

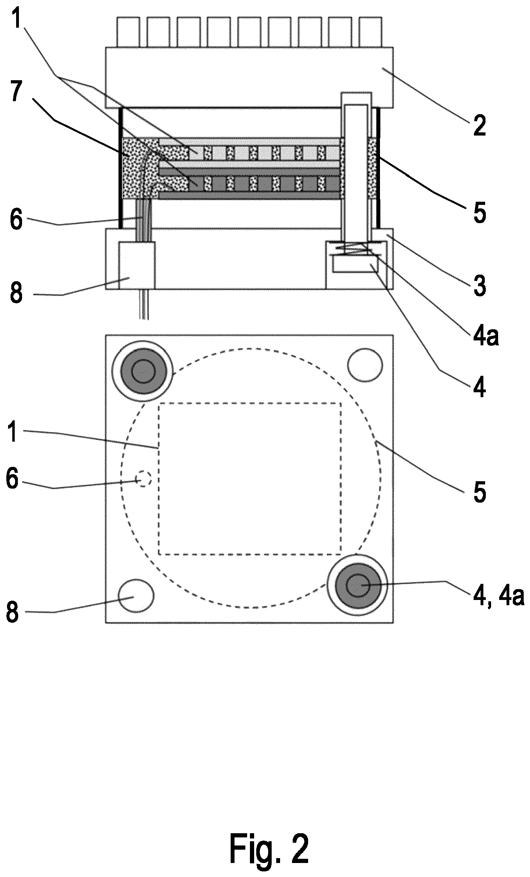

Figur 2 zeigt eine erste Ausführungsform eines erfindungsgemäßen thermoelektrischen Compound-Moduls 10. Dieses weist einen heißseitigen Wärmeübertrager 2, einen kaltseitigen Wärmeübertrager 3 und ein oder mehrere dazwischen angeordnete thermoelektrische Module 1 auf. Der kaltseitige Wärmeübertrager 3 dient der Wärmeabgabe beispielsweise an eine gekühlte Platte oder direkt an ein Kühlmedium, das ihn äußerlich umströmt oder innen durchströmt, ferner der mechanischen Befestigung 8 und der thermisch geschützten Durchführung der elektrischen Anschlüsse 6. Die Fügung des heißseitigen Wärmeübertragers 2 mit dem kaltseitigen Wärmeübertrager 3 erfolgt kraftschlüssig über mehrere Spannvorrichtungen 4, 4a, die außerhalb der Verkapselung 5 angeordnet sind. Die Verkapselung ist als Folie ausgebildet und kann beispielsweise auch in bestimmten Bereichen wellenförmig ausgebildet sein oder die Form eines Faltenbalgs aufweisen. Die Verkapselung weist im Querschnitt eine kreiszylindrische Form auf.

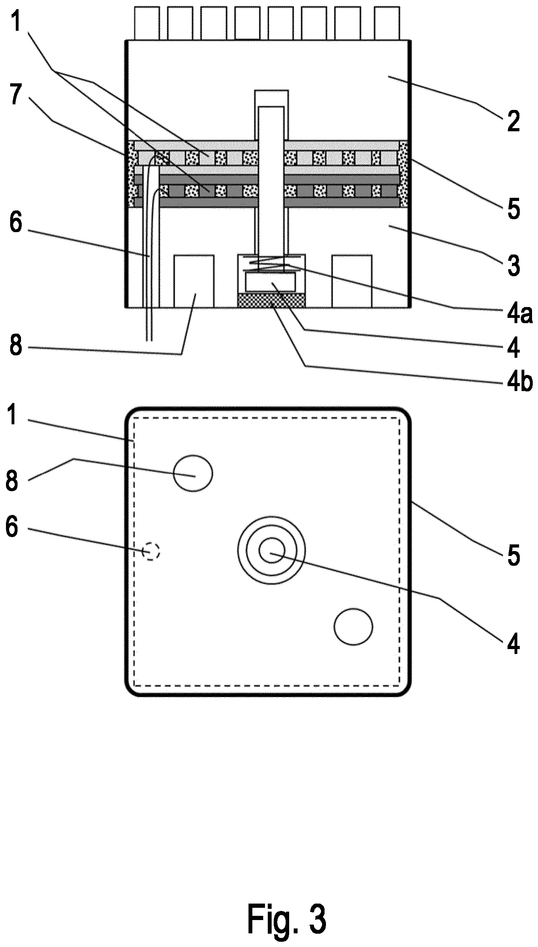

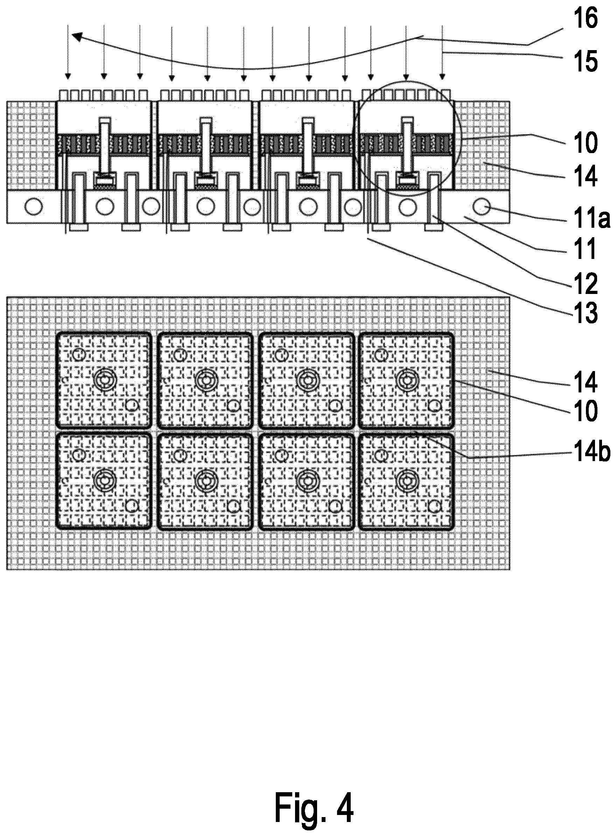

Figur 3 zeigt eine zweite Ausführungsform des erfindungsgemäßen thermoelektrischen Compound-Moduls. Hier weist die Verkapselung im Querschnitt eine quadratische oder auch rechteckige, allgemeiner eine polygonale Form auf. Sowohl die Kabeldurchführung 6 als auch die Schraube 4 zur mechanischen Befestigung sind in dieser Ausführungsform in radialer Richtung innerhalb der Verkapselung 5 angeordnet und müssen dementsprechend ebenfalls eine Abdichtung aufweisen. Mit Bezugszeichen 8 ist ein Innengewinde in einem Sackloch dargestellt. Somit kann das Compound-Modul mittels Schrauben / Gewindestangen befestigt werden (s. auch Fig. 4).

Figur 4 zeigt ein Array mit mehreren thermoelektrischen Compound-Modulen 10. Konkret sind in dieser Abbildung acht thermoelektrische Compound-Module 10 in einem Array angeordnet, wobei die Anzahl beliebig gewählt werden kann. Die thermoelektrischen Compound-Module 10 werden auf einer gekühlten Platte 11 montiert. Dies kann beispielsweise mittels Schrauben 12 erfolgen. Die Kühlung der Platte erfolgt bevorzugt durch Kühlwasserkanäle 11a. Die gekühlte Platte kann weiterhin Aussparungen für die Durchführung der elektrischen Kabelanschlüsse 13 aufweisen. Zwischen den thermoelektrischen Compound-Modulen sind Spalte ausgebildet, die deren thermische Ausdehnung ermöglichen. Diese können mit einem flexiblen, temperaturbeständigen Isoliermaterial ausgefüllt werden, beispielsweise mit Mineralwolle oder Keramikfasermatten 14b.

Die äußere Umrandung der thermoelektrischen Compound-Module kann weiterhin mit einem hitzebeständigen Isoliermaterial 14 erfolgen, um Bypass-Wärmeverluste zu minimieren.

Der Wärmeeintrag des wärmeliefernden Prozesses (Strahlungswärme, Abgasstrom, Verbrennungsprozess o.ä.) erfolgt durch thermische Strahlung (15) und/oder Konvektion (16), wobei die Geometrie der heißseitigen Blöcke für den Wärmeübertragungsvorgang entsprechend ausgelegt und angepasst wird, z.B. durch Ausformung von Rippen-, Stab- oder Noppenstrukturen oder durch Beschichtungen hoher Infrarot-Emissivität bei Strahlungswärme als Wärmequelle.

Wesentlicher Vorteile dieses Aufbaus gegenüber dem Stand der Technik ist, dass die relativ kleinen thermoelektrischen Compound-Module (TECM) sich ohne Beschädigung thermisch ausdehnen können, da zwischen den Modulen ein Spalt vorhanden ist. Die meisten bisher entwickelten thermoelektrischen Generatoren besitzen heißseitig eine durchgehende Platte über alle oder zahlreiche thermoelektrische Module, wodurch sich die thermische Dehnung über die Gesamtlänge der zusammenhängenden Struktur summiert, was zu großen thermischen Spannungen und damit beschleunigtem Versagen führt.

Je nach Auslegung bilden ein Array oder mehrere Arrays von TECM eine TE Komponente. Im Fall der Stromerzeugung wird diese als Thermoelektrischer Generator (TEG) bezeichnet. Dieser befindet sich in einem TE System, welches u.a. die Versorgung mit den heiß- und kaltseitigen Medien und die elektrische Verschaltung der TE Module beinhaltet. Im Fall der verbrennungsbasierten Stromerzeugung entspricht dieses TE System einem Blockheizkraftwerk.

Das erfindungsgemäße thermoelektrische Compound-Modul kann bei Verbrennungsprozessen beispielsweise bei Kesseln zur Warmwasserbereitstellung verwendet werden. Weiterhin bietet sich eine Nutzung der Wärme von Abgasströmen von Motoren, Gasturbinen oder Anlagen zur thermischen Nachverbrennung an. Neben dem Anwendungsfall der Stromerzeugung können TECM grundsätzlich baugleich auch zu Kühlzwecken als sogenannte Peltier-Kühler sowie zu Heiz- oder Thermalisierungszwecken als sogenannten Peltier-Wärmepumpen Anwendung finden.

## Patentansprüche

1. Thermoelektrisches Compound-Modul (10), mit
einem heißseitigen Wärmeübertrager (2) zur Kontaktierung und/oder Befestigung des thermoelektrischen Compound-Moduls (10) an eine Wärmequelle,
einem kaltseitigen Wärmeübertrager (3) zur Kontaktierung und/oder Befestigung des thermoelektrischen Compound-Moduls an einer Wärmesenke,
einem oder mehreren thermoelektrischen Modulen (1), die zwischen dem heißseitigen Wärmeübertrager (2) und dem kaltseitigen Wärmeübertrager (3) angeordnet sind,
**dadurch gekennzeichnet, dass**
das thermoelektrische Compound-Modul (10) eine Verkapselung (5) aufweist, die sich von dem heißseitigen Wärmeübertrager (2) zum kaltseitigen Wärmeübertrager (3) erstreckt und die die thermoelektrischen Module (1) vollständig umschließt und gegen äußere Einflüsse abdichtet.

2. Thermoelektrisches Compound-Modul (10) nach Anspruch 1, **dadurch gekennzeichnet, dass** der kaltseitige Wärmeübertrager (3) eine thermisch geschützte Durchführung für elektrische Anschlüsse (6) aufweist.

3. Thermoelektrisches Compound-Modul (10) nach Ansprüchen 1 oder 2, **gekennzeichnet durch** mindestens eine Spannvorrichtung (4) zur Verbindung des heißseitigen Wärmeübertragers (2) mit dem kaltseitigen Wärmeübertrager (3), wobei durch die Spannvorrichtung (4) eine definierte mechanische Anpressung vom heißseitigen Wärmeübertrager (2) und kaltseitigen Wärmeübertrager (3) an die thermoelektrischen Module (1) erfolgt, wobei die mindestens eine Spannvorrichtung (4) in radialer Richtung außerhalb der Verkapselung (5) angeordnet ist.

4. Thermoelektrisches Compound-Modul (10) nach Ansprüchen 1 - 3, **dadurch gekennzeichnet, dass** die Verkapselung (5) des thermoelektrischen Moduls (10) gasdicht ist und insbesondere eine flexible Folie aufweist, die gasdicht mit dem heißseitigen Wärmeübertrager (2) und dem kaltseitigen Wärmeübertrager (3) verbunden ist und dass die Verkapselung (5) ferner insbesondere eine gasdichte Verfüllung der Kabeldurchführung (6) aufweist.

5. Thermoelektrisches Compound-Modul (10) nach Anspruch 4, **dadurch gekennzeichnet, dass** die Folie eine Wellenform oder Ziehharmonikaform aufweist.

6. Thermoelektrisches Compound-Modul (10) nach Ansprüchen 1 - 5, **dadurch gekennzeichnet, dass** der Hohlraum (7) zwischen dem heißseitigen Wärmeübertrager (2) und dem kaltseitigen Wärmeübertrager (3) neben dem/den thermoelektrischen Modul(en) mit einem thermischen und elektrischen Isoliermaterial verfüllt ist.

7. Thermoelektrisches Compound-Modul (10) nach Ansprüchen 1 - 5, **dadurch gekennzeichnet, dass** der Hohlraum (7) zwischen dem heißseitigen Wärmeübertrager (2) und dem kaltseitigen Wärmeübertrager (3) neben dem/den thermoelektrischen Modul(en) mit einem isolierenden Gas verfüllt oder evakuiert ist.

8. Thermoelektrisches Compound-Modul (10) nach Anspruch 7, **gekennzeichnet durch** eine, bevorzugt mehrere, Spannvorrichtung(en) in der Mitte des thermoelektrischen Compound-Moduls (10), um die, insbesondere umgebend, eine gasdichte Abdichtung vorgesehen ist.

9. Thermoelektrisches Compound-Modul (10) nach Ansprüchen 1 - 8, **gekennzeichnet durch** eine Kabeldurchführung aus dem Inneren des thermoelektrischen Compound-Moduls (10) nach außen, die insbesondere eine gasdichte Abdichtung aufweist.

10. Array mit mehreren thermoelektrischen Compound-Modulen (10) gemäß einem der Ansprüche 1 - 9, die auf einer Kühlplatte (11) montiert sind, durch die insbesondere Kühlmittelkanäle (11a) und Kabeldurchführungen (13) verlaufen.

11. Array nach Anspruch 10, **dadurch gekennzeichnet, dass** zwischen den thermoelektrischen Compound-Modulen (10) Spalte ausgebildet sind, die mit einem flexiblen, temperaturbeständigen Isoliermaterial (14b) verfüllt sind.
